# FASCICULE DE BREVET EUROPEEN

(11) **EP 0 921 566 B1**
(45) Date de publication et mention de la délivrance du brevet: **07.03.2007**
(21) Numéro de dépôt: 98402905.8
(22) Date de dépôt: 20.11.1998
(51) Int. Cl.: H01L 23/485, H01L 23/31, H01L 23/00, G01P 15/08

(54) **Composant microélectromécanique, tel que microcapteur ou microactionneur reportable sur un substrat de circuit hybride**
Mikroelektromechanische Komponente, beispielsweise Mikrosensor oder Mikroaktuator, der auf ein Hybridschaltungssubstrat übertragbar ist
Microelectromechanical component, such as a microsensor or a microactuator transferable onto a hybrid circuit substrate

(30) Priorité: 21.11.1997 FR 9714608
(43) Date de publication de la demande: 09.06.1999
(73) Titulaire: ELA MEDICAL (Société anonyme), 92541 Montrouge (FR)
(72) Inventeur: Legay, Thierry, 91640 Fontenay les Briis (FR); Gilet, Dominique, 92160 Antony (FR); Van Campenhout, Yves, 94190 Saint George (FR)
(74) Mandataire: Dupuis-Latour, Dominique

(56) Documents cités:
- EP-A- 0 778 049
- WO-A-93/24956
- US-A- 4 622 574
- US-A- 5 207 102
- US-A- 5 339 216
- US-A- 5 633 785
- US-A- 5 825 091
- PATENT ABSTRACTS OF JAPAN vol. 014, no. 316 (E-0949), 6 juillet 1990 & JP 02 103967 A (MITSUBISHI ELECTRIC CORP), 17 avril 1990
- DATABASE WPI Section EI, Week 9728 Derwent Publications Ltd., London, GB; Class S02, AN 97-302017 XP002096066 & JP 09 113393 A (TOKAI RIKA DENKI KK) , 2 mai 1997

## Description

La présente invention concerne la technologie des composants microélectromécaniques, c'est-à-dire comportant une puce intégrant un microsystème réalisé par des moyens propres à la technologie des circuits intégrés, à savoir dépôt, photolithographie et micro-usinage de couches successives sur un substrat, généralement en silicium (parfois en un autre matériau, tel que verre ou quartz).

Le terme de "microsystème" se réfère à un composant permettant de transformer une grandeur physique en un signal électrique (il s'agit alors d'un microcapteur, par exemple un microaccéléromètre) ou, inversement, qui fait varier une grandeur physique, généralement sous forme d'un déplacement d'un organe mobile, par application d'un signal électrique (il s'agit alors d'un microactionneur, par exemple une micro-pompe, typiquement pour une microseringue, ou encore un micromoteur).

Ces composants comportent pour la plupart des parties mobiles effectuant des micromouvements de l'ordre du micromètre, et sont donc, par nature, très sensibles aux contraintes mécaniques de l'environnement.

Ainsi, dans le cas typique d'un microaccéléromètre, si l'on collait le composant directement sur le substrat avec une colle rigide de type résine époxy, les simples contraintes mécaniques générées par ce collage pourraient engendrer une modification de la sensibilité du microcapteur, une réduction de son aptitude à supporter des surcharges, voire le bloquer totalement.

Pour cette raison, dans l'état actuel de l'art, le report direct d'un tel composant sur un substrat de circuit hybride est délicat et nécessite l'utilisation de colles souples et d'un gel silicone pour protéger les connexions électriques. Une variante consiste à monter le dispositif sur un *chip carrier* reporté ensuite sur le substrat, mais la perte de place est alors importante.

Pour absorber les différences de coefficients de dilatation entre le matériau du substrat (céramique, verre époxy, etc.) et celui du composant (silicium, quartz, etc.), la présence d'une résine intermédiaire est néanmoins indispensable. On procède donc à un premier report du composant sur un substrat intermédiaire de silicium (l'interface silicium/silicium ne posant pas de difficulté), puis du substrat intermédiaire sur le substrat du circuit hybride, ce dernier étant par exemple en céramique, avec interposition de la résine entre ces deux substrats.

L'un des buts de l'invention est de proposer une structure particulière de composant qui permette de s'affranchir de ces difficultés, et autorise le report direct du composant sur le substrat du circuit hybride tout en préservant le microsystème des contraintes mécaniques engendrées par l'application et le durcissement d'une résine.

Un autre but de l'invention est de proposer un tel composant qui, après report sur le substrat, occupera sur ce dernier une surface identique à celle de la seule puce ; en d'autres termes, l'adjonction de résine à la puce pour l'enrobage du composant n'augmentera pas la surface occupée par le composant sur le substrat. Cette technologie, connue sous le nom de "CSP" (*Chip Scale Packaging*) est particulièrement avantageuse dans les domaines où la miniaturisation des circuits est un paramètre essentiel, comme par exemple dans celui des circuits de stimulateurs cardiaques.

À cet effet, la présente invention propose un composant microélectromécanique avec une puce comportant un microsystème réalisé notamment par dépôt, photolithographie et micro-usinage de couches successives, dans lequel le microsystème comporte une pluralité de plots de liaison électrique. Selon l'invention : la puce est pourvue d'un enrobage externe pour permettre son report sur un substrat, et cet enrobage porte en surface une pluralité de métallisations externes reliées électriquement, au travers du matériau d'enrobage, aux plots de la puce situés en vis-à-vis et noyés dans l'épaisseur du matériau d'enrobage ; le composant enrobé a dans le sens de la longueur et de la largeur sensiblement les mêmes dimensions que celles de la puce avant enrobage ; et l'enrobage n'est formé que sur une partie réduite de la puce, essentiellement dans la région des plots et des métallisations, la partie non enrobée étant une partie sensible du microsystème, préservée des contraintes mécaniques engendrées par l'application et le durcissement du matériau d'enrobage.

En d'autres termes, l'enrobage ne concerne que les connexions électriques du microsystème, qui sont liées électriquement et mécaniquement au substrat ; le reste du capteur, qui est constitué typiquement de silicium, ne nécessite pas d'enrobage et pourra reposer librement sur le substrat sans liaison rigide avec ce dernier. Ainsi, seule une petite partie (celle portant les connexions électriques), qui est de préférence une partie inactive mécaniquement, sera enrobée de résine afin de minimiser les contraintes mécaniques engendrées par le durcissement de cette résine.

Incidemment, il y a lieu de préciser que le terme d"'enrobage" ne doit pas être interprété dans un sens restrictif suggérant un enveloppement complet de la puce du composant ; ce terme ne se réfère qu'à la technologie particulière employée (*"coating"*), où la résine peut être appliquée, comme on l'expliquera plus bas, sur une face seulement du composant.

Selon diverses caractéristiques subsidiaires avantageuses :
- le composant comporte dans le sens de l'épaisseur de la puce un évidement rempli par le matériau d'enrobage, notamment un évidement latéral formé sur un rebord de la puce, et très avantageusement le matériau d'enrobage affleure la surface de la partie non enrobée ;
- les plots et les métallisations sont situés sur un même côté, de préférence un petit côté, de la puce, les métallisations s'étendant de préférence sur une face inclinée d'une arête biseautée du composant, de manière que ladite face inclinée fasse toujours un angle avec le substrat quelle que soit la configuration de report du composant sur ce substrat, à plat ou bien sur la tranche ;
- la puce est formée à partir d'une pluralité de plaquettes superposées, avec une plaquette active portant le microsystème et au moins une plaquette passive de protection scellée sur la plaquette active, et la longueur de la partie passive est inférieure à celle de la partie active de manière à former une région où les plots de contact ne sont pas recouverts par la plaquette passive et à définir dans cette région de non-recouvrement un évidement latéral rempli par le matériau d'enrobage ;
- le microsystème est un microaccéléromètre.

L'invention vise également, en tant que produit nouveau, un stimulateur cardiaque asservi comportant un microaccéléromètre incorporé dans un composant tel qu'exposé ci-dessus.

D'autres caractéristiques et avantages de l'invention apparaîtront à la lecture de la description détaillée ci-dessous d'un exemple de mise en oeuvre, en référence aux dessins annexés.

La figure 1 est une vue perspective d'un composant réalisé selon les enseignements de l'invention.

La figure 2 montre le composant de la figure 1, reporté et soudé sur un substrat selon deux configurations possibles.

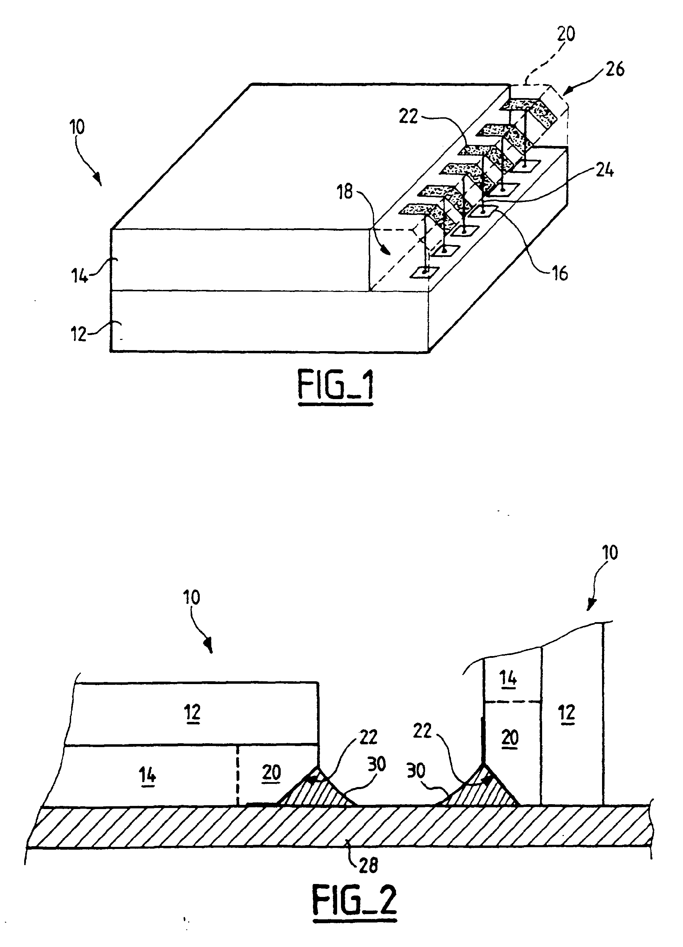

Sur la figure 1, la référence 10 désigne de façon générale le composant de l'invention, qui peut être par exemple un microaccéléromètre à un ou deux axes sensibles dans le plan de la puce, composant utilisé notamment comme capteur d'activité physique dans un stimulateur cardiaque asservi (cet exemple n'étant bien entendu aucunement limitatif, comme on l'a indiqué au début de la présente description).

Dans l'exemple considéré, le composant 10 est réalisé à partir de deux plaquettes (*"wafers"*) de silicium 12, 14 - la figure 1 ne représentant qu'un composant individuel obtenu après découpe de la plaquette entière.

La plaquette 12 est dite "active" et porte le microsystème, tandis que la plaquette 14 est dite "passive", en ce qu'elle est dépourvue d'élément électronique ou électromécanique gravé et n'assume qu'un rôle de capot de protection des éléments de la plaquette active 12. Ces deux plaquettes sont superposées et scellées par exemple par liaison (*"bonding"*) anodique ; les plaquettes 12 et 14 étant constituées du même matériau, cette liaison n'introduit dans le composant aucune contrainte mécanique à l'interface entre les deux plaquettes.

La plaquette active 12 comporte une pluralité de plots de contact ou *"pads"* 16, qui sont des plages métallisées affleurantes (comme illustré) ou situées chacune au fond d'un alvéole de la plaquette 12.

Pour permettre l'accès à ces plots de contact 16, la plaquette passive 14 comporte un évidement 18 au droit des plots 16. Cet évidement est comblé par un volume correspondant de résine d'enrobage 20, qui porte à sa surface supérieure (qui vient affleurer le niveau de la plaquette passive 14) une série de métallisations 22, en nombre identique à celui des plots 16. Les métallisations 22 et les plots respectifs 16 sont situés en vis-à-vis et sont reliés entre eux par un fil de liaison 24.

Ces liaisons électriques peuvent être réalisées selon une technique connue, exposée dans le WO-A-93/24956, dont la demanderesse est cotitulaire et où est décrit un procédé de fabrication d'un composant dont une face est complètement recouverte d'une couche d'enrobage de résine et porte une série de métallisations reliées à des plots de contact d'une puce, ces plots étant noyés sous la couche de résine. Le procédé décrit dans ce document, avec ses différentes variantes, peut parfaitement être mis en oeuvre pour la réalisation du composant de la présente invention.

L'évidement 18 peut être réalisé de façon simple avant découpe en composants individuels de l'empilement de plaquettes, par creusement dans la plaquette supérieure 14 de tranchées permettant de faire apparaître les plots de liaison 16, ces tranchées se présentant extérieurement sous forme d'un hachurage de tranchées continues (ou d'un quadrillage si le composant est pourvu de contacts sur deux côtés adjacents).

L'enrobage est alors effectué de la manière enseignée par le WO-A-93/24956 précité, mais en ne coulant la résine que dans les tranchées creusées sur la plaquette. La résine est un matériau polymérisable tel qu'un polyimide, un polymère époxy, etc. susceptible d'être coulé et durci *in situ,* par exemple par exposition aux UV ou passage en température. Après polymérisation, le matériau durci, bien que rigide, présente néanmoins une souplesse suffisante pour absorber les différences de coefficients de dilatation entre substrat et composant ainsi que les éventuelles contraintes mécaniques subies à l'interface entre ces deux éléments.

Après durcissement de cette résine, les contraintes générées sur la plaquette sont suffisamment faibles pour ne pas l'endommager et les étapes finales du processus (rodage, rainurage, dépôt des métallisations 22, ...) peuvent intervenir, toujours conformément aux enseignements du WO-A-93/24956.

Après découpe de l'empilement des plaquettes en composants individuels, la faible contrainte sur l'assemblage se libère, et le composant (microsystème enrobé) ne subit aucune variation de caractéristiques électromécaniques, ou seulement de très faibles variations.

On dispose ainsi d'un composant comportant sur l'un de ses côtés une région enrobée d'une résine métallisée adaptée au report sur un substrat hôte en un matériau différent de celui des plaquettes. Ce report est effectué comme pour un composant CMS, selon des techniques bien connues en elles-mêmes et qui ne seront pas décrites plus en détail.

La figure 2 illustre ce composant 10 reporté sur un substrat 28. De préférence, il est prévu une face biseautée 26 permettant d'augmenter la surface mouillée par la soudure 30 et, d'autre part et surtout, d'autoriser indifféremment un report à plat (à gauche sur la figure 2) ou sur la tranche (à droite sur la figure 2) du composant sur le substrat.

Ce dernier avantage est particulièrement intéressant par exemple dans le cas des microaccéléromètres, le composant reporté à plat étant par exemple un microaccéléromètre à deux axes sensibles dans le plan de la puce, et donc dans le plan du substrat, tandis que le composant reporté sur la tranche est également un microaccéléromètre avec un axe sensible dans le plan de la puce, donc perpendiculairement au plan du substrat : avec deux composants semblables reportés côte à côte on peut ainsi obtenir un système de capteurs 3D dans un repère orthonormé.

La présente description, qui correspond à une configuration avantageuse, n'est bien entendu pas limitative.

En effet, il est souhaitable que les plots de liaison (qui sont en général en nombre restreint, dans le cas des microsystèmes), soient rassemblés sur un même côté de la puce pour permettre l'enrobage seulement des connexions électriques et non de l'ensemble du microsystème.

D'autre part, un microsystème étant généralement réalisé à partir de plusieurs plaquettes superposées, pour limiter la sensibilité du composant aux contraintes il est souhaitable que la partie mécanique active du microsystème soit située sur une seule des plaquettes (la plaquette active 12 dans l'exemple décrit ci-dessus), gravée en surface et/ou en volume, et qu'une ou deux autres plaquettes (dessus et/ou dessous) réalisent la protection mécanique de la plaquette active, avec un rôle électrique limité par exemple à une fonction de blindage. De cette façon, des microcontraintes opérant sur les plaquettes passives engendreront des perturbations moindres sur le fonctionnement global du composant.

Toujours dans le cas (préférentiel mais non limitatif) d'un composant réalisé à partir d'une structure multi-plaquettes, il est également souhaitable que tous les plots de liaison au microsystème soient situés de préférence sur la plaquette active afin de faciliter l'enrobage.

## Revendications

1. Un composant microélectromécanique (10) avec une puce (12,14) comportant un microsystème réalisé notamment par dépôt, photolithographie et micro-usinage de couches successives, dans lequel le microsystème comporte une pluralité de plots de liaison électrique (16),
**caractérisé en ce que** la puce (12,14) est pourvue d'un enrobage externe (20) pour permettre son report sur un substrat (28), et cet enrobage (20) porte en surface une pluralité de métallisations externes (22) reliées électriquement, au travers du matériau d'enrobage (20), aux plots (16) de la puce situés en vis-à-vis et noyés dans l'épaisseur du matériau d'enrobage (20),
**en ce que** le composant (10) enrobé a dans le sens de la longueur et de la largeur les mêmes dimensions que celles de la puce (12, 14) avant enrobage,
et **en ce que** l'enrobage (20) n'est formé que sur une partie réduite de la puce (12,14), dans la région des plots (16) et des métallisations (22), la partie non enrobée étant une partie sensible du microsystème, préservée des contraintes mécaniques engendrées par l'application et le durcissement du matériau d'enrobage.

2. Le composant de la revendication 1, comportant dans le sens de l'épaisseur de la puce (12, 14) un évidement (18) rempli par le matériau d'enrobage.

3. Le composant de la revendication 2, dans lequel le matériau d'enrobage (20) affleure la surface de la partie non enrobée.

4. Le composant de la revendication 2, dans lequel l'évidement (18) est un évidement latéral formé sur un rebord de la puce (12, 14).

5. Le composant de la revendication 1, dans lequel les plots (16) et les métallisations (22) sont situés sur un même côté, de préférence un petit côté, de la puce.

6. Le composant de la revendication 5, dans lequel les métallisations (22) s'étendent sur une face inclinée (26) d'une arête biseautée du composant, de manière que ladite face inclinée (26) fasse toujours un angle avec le substrat (28) quelle que soit la configuration de report du composant (10) sur ce substrat (28), à plat ou bien sur la tranche.

7. Le composant de la revendication 1, dans lequel la puce (12, 14) est formée à partir d'une pluralité de plaquettes superposées, avec une plaquette active (12) portant le microsystème et au moins une plaquette passive de protection (14) scellée sur la plaquette active, et la longueur de la partie passive est inférieure à celle de la partie active de manière à former une région où les plots de contact ne sont pas recouverts par la plaquette passive et à définir dans cette région de non-recouvrement un évidement latéral (18) rempli par le matériau d'enrobage (20).

8. Le composant de la revendication 1, dans lequel le microsystème est un microaccéléromètre.

9. Un stimulateur cardiaque asservi, **caractérisé en ce qu'**il comporte un microaccéléromètre incorporé dans un composant (10) selon la revendication 8.

## Claims

1. A micro-electromechanical component (10) with a chip (12, 14) comprising a micro-system, which, in particular, is made by deposition, photolithography and micro-manufacturing of successive layers, wherein the micro-system comprises a plurality of pads (16) for electrical contact,
**characterised in that** the chip (12, 14) is provided with an external coating (20) to allow its placement on a substrate (28), and **in that** this coating (20) has a plurality of external metallizations (22) on its surface, which are electrically connected, across the coating material (20), to the oppositely located pads (16) of the chip, which are sunk within the sickness of the coating material (20),
wherein the coated component (10) has the same dimensions in the direction of length and width as the chip (12, 14) before coating, and wherein the coating (20) is only formed on a reduced part of the chip (12, 14) in the region of the pads (16) and metallizations (22), the non-coated part being a sensitive part of the microsystem, which is protected from the mechanical stresses generated by the application and hardening of the coating material.

2. The component of claim 1, comprising a clearance (18) in the direction of thickness of the chip (12, 14), filled by the coating material.

3. The component of claim 2, wherein the coating material (20) is flush with the surface of the non-coated part.

4. The component of claim 2, wherein the clearance (18) is a lateral clearance formed on an edge of the chip (12, 14).

5. The component of claim 1, wherein the pads (16) and the metallizations (22) are located on the same side, preferably a small side, of the chip.

6. The component of claim 5, wherein the metallizations (22) extend over an inclined surface (26) of a bevelled edge of the component, such that said inclined surface (26) is always at an angle with respect to the substrate (28), irrespective of the configuration of the component's (10) placement on this substrate (28), flat or on the side.

7. The component of claim 1, wherein the chip (12, 14) is formed from a plurality of superimposed plates, with an active plate (12) carrying the micro-system and at least one passive protection plate (14) fixed on the active plate, and wherein the length of the passive part is less than the length of the active part, in order to form a region where the contact pads are not covered by the passive plate, and to define a lateral clearance (18) in this non-covering region, filled by the coating material (20).

8. The component of claim 1, wherein the micro-system is a micro-accelerometer.

9. A controlled cardiac pacemaker, **characterised in that** it comprises a micro-accelerometer incorporated in a component (10) according to claim 8.

## Patentansprüche

1. Mikroelektromechanische Komponente (10) mit einem Chip (12, 14), der ein Mikrosystem umfasst, welches insbesondere durch Auftrag, Photolithographie und Mikro-Verarbeitung von aufeinander folgenden Schichten verwirklicht ist, bei welcher das Mikrosystem eine Mehrzahl von Kontakten (16) zur elektrischen Verbindung umfasst,
**dadurch gekennzeichnet, dass** der Chip (12, 14) mit einer externen Umhüllung (20) versehen ist, um dessen Anordnung auf einem Substrat (28) zu erlauben, und dass diese Umhüllung (20) an der Oberfläche eine Mehrzahl von äußeren Metallisierungen (22) aufweist, die durch das Umhüllungsmaterial (20) hindurch elektrisch mit den sich gegenüber befindlichen Kontakten (16) des Chips verbunden sind, die in der Dicke des Umhüllungsmaterials (20) versenkt sind,
wobei die umhüllte Komponente (10) in Richtung der Länge und der Breite dieselben Ausmaße wie diejenigen des Chips (12, 14) vor Umhüllung hat,
und wobei die Umhüllung (20) nur auf einem verringerten Teil des Chips (12, 14) im Bereich der Kontakte (16) und der Metallisierungen (22) ausgebildet ist, wobei der nicht umhüllte Teil ein sensibler Teil des Mikrosystems ist, der vor den durch die Anwendung und Aushärtung des Umhüllungsmaterials erzeugten mechanischen Spannungen geschützt ist.

2. Komponente nach Anspruch 1, mit einer Ausnehmung (18) in Richtung der Dicke des Chips (12, 14), die durch das Umhüllungsmaterial ausgefüllt ist.

3. Komponente nach Anspruch 2, bei welcher das Umhüllungsmaterial (20) mit der Fläche des nicht umhüllten Teils bündig ist.

4. Komponente nach Anspruch 2, bei welcher die Ausnehmung (18) eine seitliche Ausnehmung ist, die auf einer Kante des Chips (12, 14) ausgebildet ist.

5. Komponente nach Anspruch 1, bei welcher die Kontakte (16) und die Metallisierungen (22) sich auf einer selben Seite des Chips befinden, vorzugsweise einer kleinen Seite.

6. Komponente nach Anspruch 5, bei welcher die Metallisierungen (22) sich über eine geneigte Fläche (26) einer abgeschrägten Kante der Komponente erstrecken, so dass die geneigte Fläche (26) stets in einem Winkel zum Substrat (28) steht, unabhängig von der Konfiguration der Anordnung der Komponente (10) auf diesem Substrat (28), flach oder auf der Seite liegend.

7. Komponente nach Anspruch 1, bei welcher der Chip (12, 14) aus einer Mehrzahl von übereinander liegenden Platten gebildet ist, mit einer das Mikrosystem aufweisenden aktiven Platte (12) und wenigstens einer passiven Schutzplatte (14), die auf der aktiven Platte fixiert ist, und wobei die Länge des passiven Teils geringer als diejenige des aktiven Teils ist, um so einen Bereich zu bilden, wo die Kontakte nicht von der passiven Platte bedeckt sind, und in diesem nicht bedeckten Bereich eine seitliche Ausnehmung (18) zu definieren, die von dem Umhüllungsmaterial (20) ausgefüllt ist.

8. Komponente nach Anspruch 1, bei welcher das Mikrosystem ein Mikro-Beschleunigungsmesser ist.

9. Geregelter Herzschrittmacher, **dadurch gekennzeichnet, dass** er einen Mikro-Beschleunigungsmesser umfasst, der in eine Komponente (10) nach Anspruch 8 eingebaut ist.
